# EUROPEAN PATENT APPLICATION

(11) **EP 4 614 522 A1**
(43) Date of publication of application: **10.09.2025**
(21) Application number: 24162254.7
(22) Date of filing: 08.03.2024
(51) Int. Cl.: G21K 1/00, G06N 10/40

(54) **ELECTRONIC COMPONENT INCLUDING MIRROR AND ELECTRONIC CIRCUIT**

(71) Applicant: Infineon Technologies Austria AG, 9500 Villach (AT)
(72) Inventor: RÖSSLER, Clemens, 9500 Villach (AT); COLOMBE, Yves, 9500 Villach (AT); ZESAR, Alexander, 9500 Villach (AT); SCHÜPPERT, Klemens Karl Heinrich, 9584 Goritschach (AT)
(74) Representative: Lambsdorff & Lange Patentanwälte Partnerschaft mbB

(57) **Abstract**

An electronic component includes a semiconductor substrate having a first major surface and a second major surface opposing the first major surface. The electronic component further includes an electronic circuit integrated into the semiconductor substrate and a mirror arranged over the semiconductor substrate, wherein at least a portion of the mirror is inclined with respect to the first major surface of the semiconductor substrate. The electronic component further includes at least one electrical contact configured to provide an electrical coupling between the electronic circuit and at least one electrode of an ion trap.

## Description

### Technical Field

The present disclosure relates to electronic components including a mirror and an electronic circuit. In addition, the present disclosure relates to devices for controlling trapped ions including such electronic components.

### Background

Ion trap devices may be used for various applications, such as trapped-ion quantum computers, where dozens of trapped ions may need to be controlled with a low two-qubit error rate. Other applications may be atomic clocks. Typically, ion trap devices may require multiple lasers per (ion) processing zone and a plurality of electrodes per trapped ion. When scaling ion trap devices to larger sizes, an increasing number of the mentioned components may become a major challenge in terms of optical and electrical access to the ion trap.

It may be desirable to improve an optical and electrical access to the ion traps. In addition, the solutions developed may support a straightforward and easy scaling of ion trap devices that may increase the number of trapped ions.

### Summary

An aspect of the present disclosure relates to an electronic component. The electronic component comprises a semiconductor substrate having a first major surface and a second major surface opposing the first major surface. The electronic component further comprises an electronic circuit integrated into the semiconductor substrate and a mirror arranged over the semiconductor substrate, wherein at least a portion of the mirror is inclined with respect to the first major surface of the semiconductor substrate. The electronic component further comprises at least one electrical contact configured to provide an electrical coupling between the electronic circuit and at least one electrode of an ion trap.

A further aspect of the present disclosure relates to an ion trap comprising the electronic component of the previous aspect.

A further aspect of the present disclosure relates to a device for controlling trapped ions. The device comprises a substrate having a main surface and a structured electrode layer arranged over the main surface of the substrate, wherein the structured electrode layer forms a plurality of electrodes of an ion trap configured to trap ions in a zone above the structured electrode layer. The device further comprises at least one electronic component arranged over the main surface of the substrate. Each of the at least one electronic component comprises a semiconductor substrate and an electronic circuit integrated into the semiconductor substrate, wherein the electronic circuit is electrically coupled to at least one of the plurality of electrodes of the ion trap. In addition, each of the at least one electronic component comprises a mirror arranged over the semiconductor substrate, wherein at least a portion of the mirror is inclined with respect to the main surface of the substrate.

### Brief Description of the Drawings

Devices in accordance with the disclosure are described in more detail below based on the drawings. Similar reference numerals may designate corresponding similar parts. The technical features of the various illustrated examples may be combined unless they exclude each other and/or can be selectively omitted if not described to be necessarily required.
Figure 1 schematically illustrates a top view of a structured electrode layer of a device for controlling trapped ions in accordance with the disclosure.
Figure 2 includes Figures 2A and 2B schematically illustrating a top view and a side view of an electronic component 200 in accordance with the disclosure.
Figure 3 includes Figures 3A and 3B schematically illustrating a top view and a side view of a device 300 for controlling trapped ions in accordance with the disclosure.
Figure 4 includes Figures 4A and 4B schematically illustrating a top view and a side view of a device 400 for controlling trapped ions in accordance with the disclosure.
Figure 5 includes Figures 5A and 5B schematically illustrating a top view and a side view of a device 500 for controlling trapped ions in accordance with the disclosure.
Figure 6 includes Figures 6A and 6B schematically illustrating a top view and a side view of a device 600 for controlling trapped ions in accordance with the disclosure.
Figure 7 includes Figures 7A and 7B schematically illustrating a top view and a side view of a device 700 for controlling trapped ions in accordance with the disclosure.
Figure 8 includes Figures 8A and 8B schematically illustrating a top view and a side view of a device 800 for controlling trapped ions in accordance with the disclosure.
Figure 9 includes Figures 9A to 9C schematically illustrating a top view of a device 900 for controlling trapped ions in accordance with the disclosure as well as a top view and a side view of a detail of the device 900.

### Detailed Description

The following description relates to electronic components that may be included in devices for controlling trapped ions (ion trap devices). In addition, the following description relates to ion trap devices including such electronic components. The ion trap devices described herein may be configured to trap ions and control the trapped ions. It is to be noted that the following description is not restricted to ions, but may also be applied to atoms, molecules or other quantum particles/systems (e.g. electrons or defect centers). In particular, the trapped ions may be physically grouped in ion chains (or ion strings or ion crystals), wherein an ion chain may include one or more ions. In the following, the terms "ion" and "ion chain" may be used interchangeably at times.

In some examples, the devices described herein may be used for quantum computing, but are not restricted thereto. Trapped ions are one of the most promising candidates for being used as qubits in quantum computers, since they can be trapped with rather long lifetimes by means of electromagnetic fields. In this context, each ion may represent a physical qubit. However, ion trap devices in accordance with the disclosure are not restricted to the application of quantum computing. The ion trap devices presented herein may also be used for other applications, such as atomic clocks.

The ions trapped in an ion trap device may be shuttled (or transported) along shuttling paths of the device. The shuttling paths may include straight sequences, but also junctions, such as X-junctions, Y-junctions and/or T-junctions. For example, the shuttling paths may extend above a structured electrode layer including a plurality of electrodes. In particular, a shuttling path may be arranged in a plane over such structured electrode layer. Time-dependent electric fields may be used for shuttling ions along the shuttling paths. A shuttling of ions may be controlled by electric voltages applied to the electrodes of the structured electrode layer. In some examples, the ions may be moved along shuttling paths by means of AC and DC voltages that may be separately coupled to specific electrodes of the structured electrode layer. For example, the structured electrode layer may include RF electrodes for RF trapping and DC electrodes for static electric-field trapping and/or for moving the ions within the ion trap. As another example, ions may be confined by the combination of an external magnetic field and electrostatic quadrupole fields generated by voltages applied to DC electrodes. Ion trap devices as described herein may be configured to trap a plurality of ions that may be individually addressable and movable by appropriately controlling the electric potentials of the electrodes.

In a specific but non-limiting example, ion trap devices as described herein may correspond to or may include a surface ion trap (or surface-electrode ion trap). In surface ion traps, all electrodes (i.e. the DC electrodes and the RF electrodes) may be arranged in a same single plane. The ions may be stored and shuttled above this single plane. However, it is to be understood that the concepts described herein are not restricted to surface ion traps. In further examples, devices for controlling trapped ions in accordance with the disclosure may also be based on three-dimensional ion trap geometries (e.g., where two or more trapping planes are arranged on top of each other).

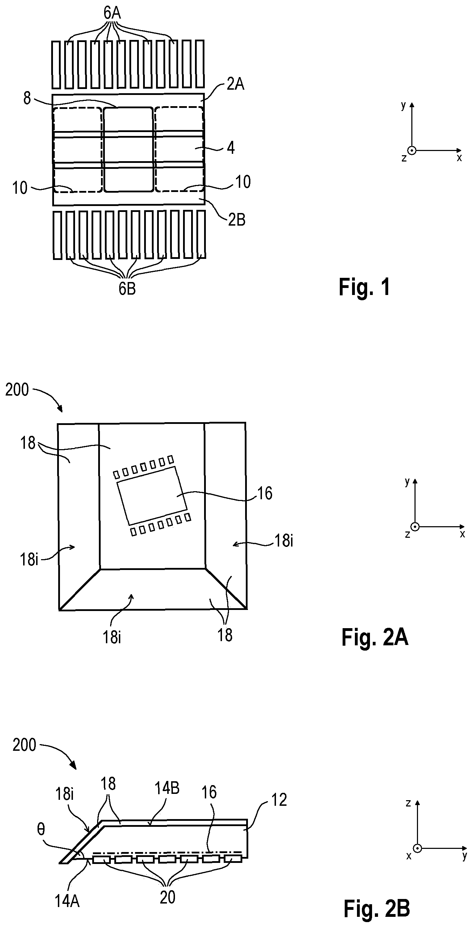

Referring now to Figure 1, a top view of an exemplary structured electrode layer of an ion trap device is illustrated. The structured electrode layer may include a first RF electrode 2A and a second RF electrode 2B extending along a first direction, for example in the x-direction. A shuttling path of the ion trap device may extend along the RF electrodes 2A and 2B. In addition, the structured electrode layer may include a center DC electrode 4 arranged between the first RF electrode 2A and the second RF electrode 2B. The center DC electrode 4 may extend along the x-direction in parallel to the RF electrodes 2A and 2B. In particular, the center DC electrode 4 may be arranged directly below ions trapped above the structured electrode layer. The structured electrode layer may further include a first plurality of first DC electrodes 6A arranged adjacent to the first RF electrode 2A and a second plurality of second DC electrodes 6B arranged adjacent to the second RF electrode 2B. The DC electrodes 6A and 6B may be referred to as DC shuttling electrodes and may be arranged opposite to the center DC electrode 4. In practice, dozens, hundreds or even thousands of DC electrodes 6A and 6B may be arranged in an ion trap device along RF electrodes 2A and 2B.

In the illustrated example, the structured electrode layer may be referred to as five-wire geometry. It is however to be understood that aspects described herein are not restricted to five-wire geometries, but may also hold true for other types of ion traps and/or electrode geometries. In one case, the structured electrode layer may be fabricated with a single structured, highly conductive metal layer for low manufacturing complexity. In further cases, several structured metal layers may be required for more complex ion trap geometries. For example, the structured electrode layer may include or may be made of Al, AlCu, AlSiCu, W, TiW, Ti, TiN, Cu, Pt, Pd and/or Au. In a non-limiting example, dimensions of the illustrated structured electrode layer in the x- and y-direction may be about 300um and about 500pm, respectively. However, these values are in no way limiting and are only intended to illustrate an order of magnitude of the dimensions of the illustrated arrangement.

Devices for controlling trapped ions may include different zones providing basic functionalities required for an operation of the ion trap device. In the illustrated example, such zones are exemplarily indicated by a solid rectangle and two dashed rectangles. The solid rectangle may e.g. indicate a processing zone 8 of the ion trap device. For example, the processing zone 8 may include or may correspond to a gate zone for performing quantum gate operations on ions trapped in the gate zone. Each of the dashed rectangles may indicate a shuttling and/or splitting zone 10 in which an ion chain may be shuttled, split and/or recombined. It is to be understood that ion trap devices as described herein may also include other types of zones, such as memory zones, state readout zones, loading zones, etc. It is further to be understood that the illustrated example of Figure 1 only shows a basic portion of an ion trap device. In practice, ion trap devices may include a plurality of shuttling paths which may be connected by junctions, such as T-junctions, Y-junctions and/or X-junctions.

Figures 2A and 2B illustrate a top view and a side view of an electronic component 200 in accordance with the disclosure. In particular, the electronic component 200 may be included in a device for controlling trapped ions. The electronic component 200 may include a semiconductor substrate 12 having a first major surface 14A and a second major surface 14B opposing the first major surface 14A. For example, the semiconductor substrate 12 may include or may be made of silicon. The electronic component 200 may further include an electronic circuit 16 integrated into the semiconductor substrate 12 and a mirror 18 arranged over the semiconductor substrate 12. At least a portion 18i of the mirror 18 may be inclined with respect to the first major surface 14A of the semiconductor substrate 12. Furthermore, the electronic component 200 may include at least one electrical contact 20 configured to provide an electrical coupling between the electronic circuit 16 and at least one electrode of an ion trap.

The electronic circuit 16 may be configured to provide one or multiple electronic functions. For example, the electronic circuit 16 may include a multiplexer configured to provide a multiplexing between a plurality of DC electrodes of an ion trap and one or multiple voltage sources. In this regard, the electronic circuit 16 (or the multiplexer included therein) may include a digital interface. Referring back to the example of Figure 1, one or more voltage sources may provide DC voltages that need to be distributed to the multiple DC electrodes 6A and 6B. The multiplexing feature of the electronic circuit 16 may provide such distribution of voltage signals. As will become apparent later on, the large number of hundreds or even thousands of DC electrodes may be broken down to only a few or dozens of signal lines and/or contacts coupled to the voltage sources.

The electronic circuit 16 is not necessarily restricted to a pure distribution of DC voltages to the DC electrodes 6A and 6B. The electronic circuit 16 may further include digital electronics for controlling the one or multiple voltage sources. For example, control logic of the electronic circuit 16 may be configured to provide stored wave forms that may be used for a suitable generation of DC voltages. In some examples, the electronic circuit 16 may include a plurality of digital-to-analog converters configured to generate DC voltages that may be provided to the DC electrodes 6A and 6B.

The electronic circuit 16 may include or may correspond to an integrated circuit. The electronic circuit 16 may be integrated into the first major surface 14A of the semiconductor substrate 12 as indicated by a dot-dashed line in the exemplary side view of Figure 2B. In the top view of Figure 2A, the electronic circuit 16 is exemplarily illustrated as a rectangular integrated circuit having electronic contacts on opposing sides. However, it is to be understood that the chosen illustration only serves as a simplified representation of the electronic circuit 16 and is in no way limiting.

The mirror 18 may include or may correspond to at least one reflective surface. The mirror 18 may be manufactured from any suitable reflective material, such as a metal. The mirror 18 may be configured to reflect incoming laser light hitting the reflective surface of the mirror 18. In this regard, the mirror 18 may be configured to reflect at least 97% or at least 98% or at least 99% or at least 99.5% percent of incident laser light. In some examples, the mirror 18 may be configured to reflect substantially 100% of the incident laser light. The laser light may have a wavelength in a range from about 150nm to about 4um, but is in general not restricted to a specific value or range of values. For example, the laser light may be used for processing and/or cooling ions trapped above a structured electrode layer.

In the illustrated example, one or more inclined portions 18i of the mirror 18 may include a flat surface and may be arranged directly on the semiconductor substrate 12. For example, the semiconductor substrate 12 may be etched by a wet etching and/or a chemical etching technique such that an inclined surface of the substrate 12 may be provided onto which the mirror 18 may be applied. In other words, the backside of substrate 12 (i.e., the side opposite to the side where electronic circuit 16 is formed) of electronic component 200 may be processed so that an inclined portion may be formed. On this inclined portion of substrate 12 a mirror 18 with inclined portion 18i can be fabricated. Additionally, or alternatively, one or more inclined portions 18i of the mirror 18 may include a concave surface. In order to realize such concave surface, a glass substrate (not illustrated) may be arranged between the semiconductor substrate 12 and the mirror 18. The glass substrate may include a concave surface onto which the mirror 18 may be deposited.

In the illustrated example, an angle θ between the flat surface of the inclined mirror portion 18i and the first major surface 14A of the semiconductor substrate 12 may have a non-limiting value of about 45 degrees. In further examples, the angle θ may differ and may generally have a value in a range from about 20 degrees to about 160 degrees. The angle θ may be chosen depending on the direction of incoming laser light that is to be reflected by the mirror 18. In one case, laser light may hit the mirror 18 in the negative z-direction (i.e. from top to bottom) and the angle θ may be smaller than 90 degrees. In another case, laser light may hit the mirror 18 in the positive z-direction (i.e. from bottom to top) and the angle θ may be greater than 90 degrees.

The inclined portion 18i of the mirror 18 may cover a side surface of the semiconductor substrate 12 extending between the first major surface 14A and the second major surface 14B. In the illustrated example, the mirror 18 may cover three side surfaces and the top surface of the semiconductor substrate 12. In further examples, the top surface of the semiconductor substrate 12 may remain uncovered by the mirror 18. In yet further examples, only one or more selected side surfaces of the semiconductor substrate 12 may be covered by the mirror 18 depending on the desired directions of laser light reflection.

In the exemplary top view of Figure 2A, the electronic component 200 may have the shape of a square or a rectangle. In a non-limiting example, dimensions of the electronic component 200 in the x- and y-direction may be in a range from about 500pm to about 1mm each. However, these values are in no way limiting and are only intended to illustrate an order of magnitude of the dimensions of the illustrated arrangement. In further examples, the shape and dimensions of the electronic component 200 may differ depending on the considered application.

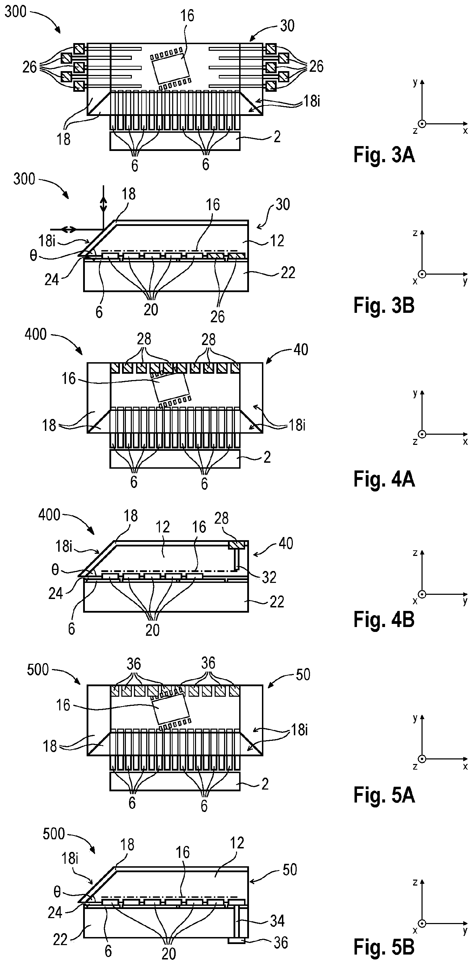

Referring now to Figures 3 to 5, various examples for connecting and interfacing an electronic component in accordance with the disclosure to a structured electronic layer of an ion trap device are illustrated and described. It is to be understood that the described examples may be combined to further examples, provided this is not technically or logically excluded.

Figures 3A and 3B illustrate a device for controlling trapped ions in accordance with the disclosure. The device 300 may include a substrate 22 having a main surface 24. The substrate 22 may include or may be made of a dielectric material or a semiconductor material. For example, the substrate 22 may include or may be made of at least one of silicon, silicon carbide, fused silica, sapphire, glass, aluminum nitride, diamond, or the like. A structured electrode layer may be arranged over the main surface 24 of the substrate 22. The structured electrode layer may form a plurality of electrodes of an ion trap configured to trap ions in a zone above the structured electrode layer. For example, the structured electrode layer may be similar to the example of Figure 1, but is not restricted thereto. In the illustrated example, one RF electrode 2 and a plurality of DC electrodes 6 are shown, while further possible RF and DC electrodes are not illustrated for the sake of simplicity.

The device 300 may include at least one electronic component 30 which may be at least partially similar to the example of Figure 2 and may include the same or similar components. The electronic component 30 may be arranged over the main surface 24 of the substrate 22, wherein the first major surface 14A of the electronic component 30 including the integrated electronic circuit 16 may face towards the main surface 24. In the illustrated example, the electrical contacts 20 of the electronic component 30 may include or may correspond to flip chip contact pads and the electronic component 30 may be mounted on the main surface 24 of the substrate 22 by a flip chip technique. The electrical contacts 20 may be configured to provide an electrical coupling between the electronic circuit 16 and the structured electrode layer. In particular, the electrical contacts 20 may be electrically coupled to the DC electrodes 6 of the structured electrode layer.

The device 300 may further include a plurality of electrical contacts 26 that may be electrically coupled to the electronic circuit 16. In the top view of Figure 3A, the electronic circuit 16 is illustrated as a symbol only for the sake of simplicity. However, it is to be noted that the electrical contacts 26 and also the DC electrodes 6 may be electrically connected to the logic area of the electronic circuit 16 even though details of such electrical connections are not explicitly illustrated. In one example, such electrical connections may be provided by an electrical redistribution layer that may be arranged at or on the first major surface 14A and may be configured to electrically connect the logic area of the electronic circuit 16 to the DC electrodes 6 and/or the electrical contacts 26.In the illustrated example, the electrical contacts 26 may include or may correspond to wire bond pads that may be formed in a same metal layer as the structured electrode layer of the ion trap. In the top view of Figure 3A, the electrical contacts 26 may be arranged at or adjacent to the outline of the electronic component 30. In the illustrated example, an exemplary number of five electrical contacts 26 may be arranged at the left and the right side of the electronic component 30, respectively. In further examples, the number of electrical contacts 26 may differ. The electrical contacts 26 may be configured to provide an electrical access to the electronic circuit 16 from outside of the electronic component 30. For example, one or more voltage sources may be electrically coupled to the electrical contacts 26.

A multiplexer of the electronic circuit 16 may provide a multiplexing between the one or more voltage sources connected to the electrical contacts 26 and the plurality of DC electrodes 6 connected to the electrical contacts 20. Accordingly, DC voltages required for a proper shuttling of trapped ions along shuttling paths may be distributed to the DC electrodes 6. In practice, the number of DC electrodes 6 may be higher than the number of electrical contacts 26 by one or more orders of magnitude. For example, the structured electrode layer may include hundreds or even thousands of DC electrodes, while the number of electrical contacts 26 may be in the range of only a few or dozens. For example, a multiplexer of electronic circuit 16 may provide a same voltage or a same voltage profile to a plurality of DC electrodes 6. The high number of DC electrodes 6 may thus become accessible via the smaller number of electrical contacts 26. The comparatively smaller number of electrical contacts 26 may support a scaling of the ion trap device to larger sizes.

The mirror 18 of the electronic component 30 may be configured to receive laser light in a direction substantially non-parallel to the main surface 24 of the substrate 22 and to redirect the laser light in a direction substantially parallel to the main surface 24. In the illustrated example, laser light hitting the reflective surface of the mirror 18 in the (negative) z-direction may be reflected and redirected in the (negative) y-direction. Additionally, or alternatively, the mirror 18 of the electronic component 30 may be configured to receive laser light in a direction substantially parallel to the main surface 24 of the substrate 22 and to redirect the laser light in a direction substantially non-parallel to the main surface 24. In the illustrated example, laser light hitting the reflective surface of the mirror 18 in the (positive) y-direction may be reflected and redirected in the (positive) z-direction. It is to be understood that incident laser light may be reflected by the mirror 18 in various other ways depending on the angle θ between the inclined portion 18i of the mirror 18 and the first major surface 14A of the electronic component 30. Possible values for the angle θ have been previously discussed in connection with the example of Figure 2.

In the exemplary side view of Figure 3B, the main surface 24 of the substrate 22 may be substantially planar. In further examples, the substrate 22 may include one or more recesses formed in the main surface 24. The electronic component 30 may be arranged in such recess, wherein a distance between the main surface 24 and a laser beam reflected by the mirror 18 and extending parallel to the main surface 24 may be reduced. In this way, the laser light may reach ions trapped over the structured electrode layer at lower heights. For example, ions may be trapped over the main surface 24 of the substrate 22 at heights of about 100um or smaller.

The electronic component 30 used in the ion trap device 300 may provide a combination of two technical functions. First, the electronic component 30 may provide an efficient and simplified electrical access to the high number of DC electrodes 6 via only a few electrical contacts 26. No (or only few) additional electrical connections, such as Through Silicon Vias (TSVs) and/or Through Glass Vias (TGVs), may thus be necessary for a suitable electrical access of the DC electrodes 6. Second, the electronic component 30 may provide an efficient and simplified way for laser light to access the ion trap device and reach the ions trapped over the structured electrode layer. Incoming laser light may be directed in various ways by choosing a suitable orientation of the inclined portion of the mirror 18. Accordingly, a number of photonic layers integrated into the ion trap device may be reduced. In particular, an effort of fabricating a high number of gratings and waveguides and connecting them with optical fibers may be reduced. It is to be noted that the described electrical and optical access combined in only one component may support a scaling of ion traps to larger sizes.

The device 300 may be manufactured in various ways. In a first example of production, a first wafer including a plurality of electronic components 30 may be wafer-bonded to a second wafer including the substrate 22 and a plurality of structured electronic layers arranged thereon. After wafer-bonding, the wafer stack may be singulated (e.g. diced) into a plurality of ion trap devices as e.g. shown in the example of Figure 3. It is to be understood that a bonding of the wafers is not restricted to a specific technique and may naturally depend on the materials of the involved wafers. In general, any suitable wafer-bonding technique may be used, such as one or more of glass-bonding techniques, eutectic bonding techniques, anodic bonding techniques, thermocompression bonding techniques, or the like. In one example, anodic bonding may be performed for forming an anodic aluminum/glass wafer-bond. In a further example, a different wafer-bonding technique may be used for enabling sapphire substrates providing superior thermal conductivity. In a second example of production, each of the first wafer and the second wafer may be diced into a plurality of electronic components and structured electronic layers on a substrate, respectively. Afterwards, the singulated elements may be chip-stacked to form arrangements as e.g. illustrated in the example of Figure 3. In this regard, it is to be noted that the first example of wafer-bonding may provide an improved accuracy in terms of alignment and tilt.

Figures 4A and 4B schematically illustrate a device 400 for controlling trapped ions in accordance with the disclosure. The device 400 may include some or all features of previously described devices. An electronic component 40 of the device 400 may include one or more electrical contacts 28 arranged over the second major surface 14B of the semiconductor substrate 12. For example, the electrical contacts 28 may include or may correspond to wire bond pads. Furthermore, the electronic component 40 may include one or more electrical connection elements 32 extending through the semiconductor substrate 12. For example, the electrical connection elements 32 may include or may correspond to TSVs. The electrical connection elements 32 may provide an electrical coupling between the electronic circuit 16 and the electrical contacts 28 arranged at the second major surface 14B. Accordingly, at least some of the DC electrodes 6 may be electrically accessible via the electrical contacts 28 at the second major surface 14B. In particular, one or more voltage sources may be electrically connected to the wire bond pads 28 via wires.

Figures 5A and 5B schematically illustrate a device 500 for controlling trapped ions in accordance with the disclosure. The device 500 may include some or all features of previously described devices. The device 500 may include one or more electrical connection elements 34 extending through the substrate 22. For example, the electrical connection elements 34 may include or may correspond to TSVs and/or TGVs depending on the material of the substrate 22. In particular, the electrical connection elements 34 may extend from the upper surface of the substrate 22 to its bottom surface, thereby providing an electrical connection between the electrical contacts 20 of the electronic component 50 and electrical contacts 36 arranged at the bottom surface of the substrate 22. In one example, the electrical contacts 36 may include or may correspond to flip chip contacts pads onto which one or multiple solder balls may be placed.

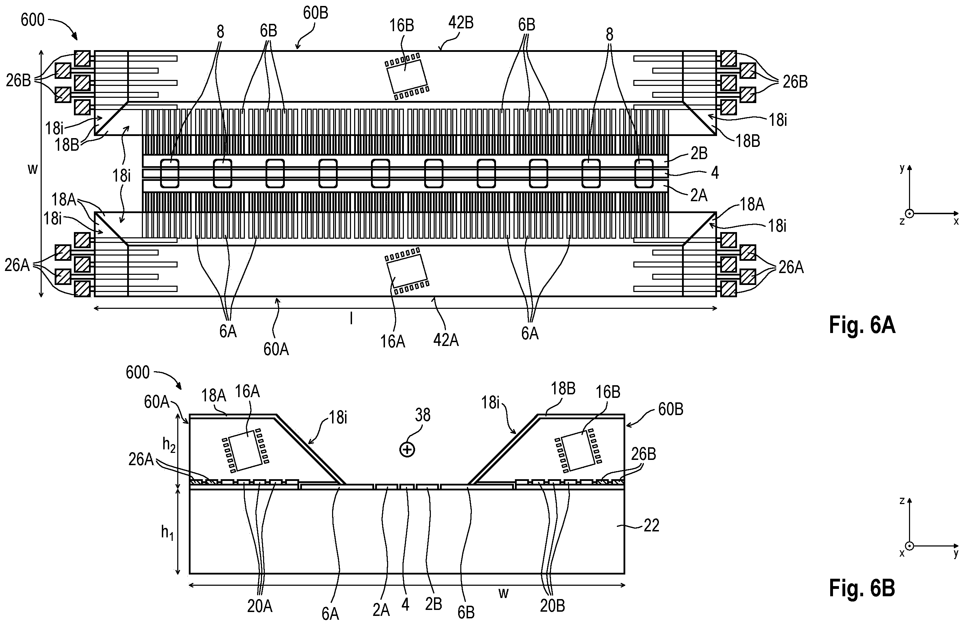

Referring now to Figures 6 to 9, various applications are illustrated in which electronic components in accordance with the disclosure may be used. The illustrated examples relate to different types of ion traps suitable for an application in a quantum processing unit or an atomic clock.

Figures 6A and 6B illustrate a device 600 for controlling trapped ions in accordance with the disclosure. The device 600 may include a substrate 22 and a structured electrode layer arranged over the upper main surface of the substrate 22. In one example, the structured electrode layer of Figure 6 may be based on a five-wire geometry as previously described in connection with Figure 2. The plurality of electrodes may be part of an ion trap configured to trap ions 38 in a zone above the structured electrode layer. The trapped ions 38 may be shuttled along the x-direction by means of suitable AC and DC voltages separately applied to the RF and DC electrodes of the structured electrode layer, respectively. The displayed trap design may avoid RF/DC routing crossings in order to facilitate low RF capacitance and/or low RF/DC pickup. The device 600 may include one or multiple processing zones 8 arranged along the x-direction. The device 600 may be referred to as one-dimensional ion trap (in particular 1D Top-IC Trap) and may be used for quantum computing in one example.

In the illustrated case, the structured electrode layer may extend along the x-direction. The device 600 may include two electronic components 60A and 60B that may be arranged on opposite sides of the structured electrode layer. In particular, the electronic components 60A and 60B may be designed and arranged symmetrically with respect to a shuttling path extending along the x-direction above the center DC electrode 6. In the exemplary top view of Figure 6A, each of the electronic components 60A and 60B may have a rectangular footprint. The inclined portions 18i of the mirrors 18A and 18B may extend over three side surfaces of the respective semiconductor substrate 12. Incoming laser beams may reach the trapped ions 38 by being reflected at the tilted sidewalls of the mirrors 18A and 18B. In addition, some axial laser access in the x-direction may be maintained. The electronic components 60A and 60B may have been obtained from dicing a wafer stack such that a fourth side surface of the respective semiconductor substrate 12 may include a dicing edge 42.

In a non-limiting example, dimensions of the device 600 and the electronic components 60A, 60B may be as follows. Dimensions 1 and w of the device 600 in the x- and y-direction may be about 4.5mm and 1.5mm, respectively. A dimension *h₁* of the substrate 22 in the z-direction may be greater than about 400um. A dimension *h₂* of the electronic components 60A and 60B in the z-direction may be about 200µm. However, these values are in no way limiting and are only intended to illustrate an order of magnitude of the dimensions of the illustrated arrangement.

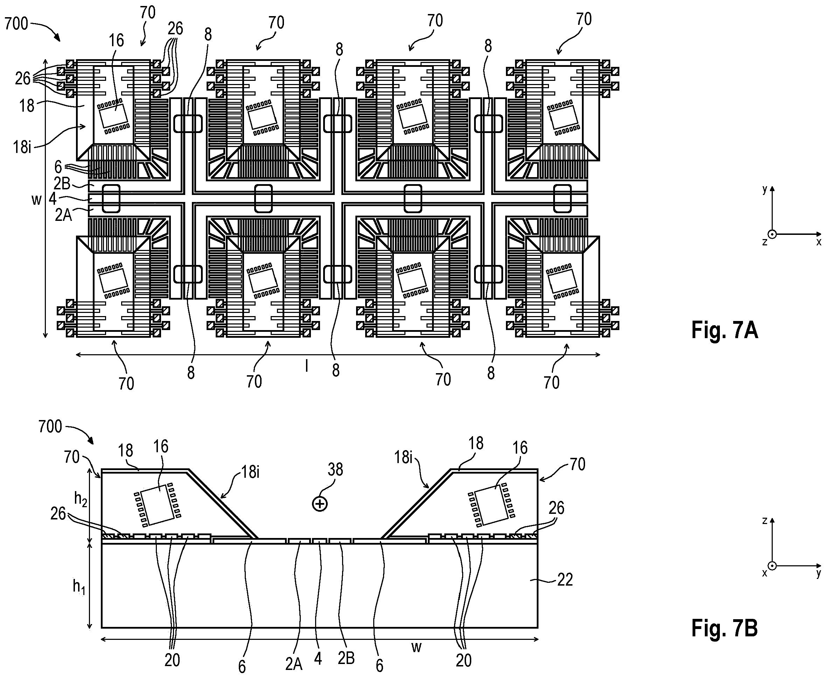

Figures 7A and 7B illustrate a device 700 for controlling trapped ions in accordance with the disclosure. The device 700 may include a substrate 22 and a structured electrode layer arranged over the substrate 22. In addition, the device 700 may include a plurality of electronic components 70 which may be arranged over the structured electrode layer in a rectangular grid pattern. In the illustrated example, each electronic component 70 may have a rectangular footprint and may be at least partially similar to electronic components described in connection with previous examples.

In the illustrated example, ions 38 trapped above the structured electrode layer may be shuttled along shuttling paths extending in the x- and y-direction. In particular, the structured electrode layer may form a rectangular grid pattern of shuttling paths extending between the plurality of electronic components 70. A plurality of X-junctions may be arranged at intersections of the shuttling paths. The illustrated ion trap layout using X-junctions may provide shorter ion-shuttling distances and fewer SWAP operations compared to other ion trap layouts. The device 700 may further include a plurality of processing zones 8 that may be arranged between opposite electronic components 70. The device 700 may be referred to as 3X Top-IC Trap and may e.g. be used for quantum computing.

Similar to previous examples, the trap design of Figure 7 may be free of RF/DC crossings and may show low RF capacitance. A production of the device 700 may be based on a single-layer trap fabrication. In a non-limiting example, dimensions of the device 700 and the electronic components 70 may be as follows. Dimensions *l* and w of the device 700 in the x- and y-direction may be about 3.5mm and 1.5mm, respectively. A dimension *h₁* of the substrate 22 in the z-direction may be greater than about 400um. A dimension *h₂* of the electronic components 70 in the z-direction may be about 100um. However, these values are in no way limiting and are only intended to illustrate an order of magnitude of the dimensions of the illustrated arrangement.

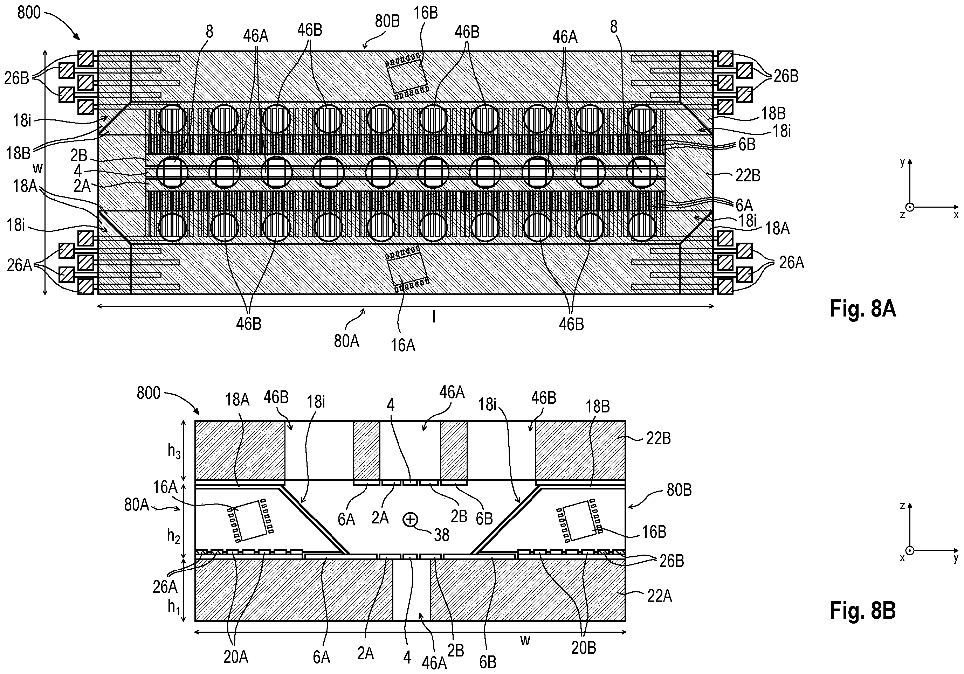

Figures 8A and 8B illustrate a device 800 for controlling trapped ions in accordance with the disclosure. The device 800 may include a first substrate 22A and a first structured electrode layer arranged over the first substrate 22A. In addition, the device 800 may include two electronic components 80A and 80B arranged over the first structured electrode layer. The first structured electrode layer and the electronic components 80A, 80B of Figure 8 may be at least partially similar to corresponding components described in connection with the example of Figure 6.

The device 800 may further include a second substrate 22B arranged over the electronic components 80A and 80B. The second substrate 22B may be at least partially similar to the first substrate 22A. The electronic components 80A and 80B may serve as spacer elements configured to define a space 44 between the two substrates 22A and 22B in which ions 38 may be trapped. In one example, the substrates 22A and 22B may be made of a glass material such that the illustrated arrangement may correspond to a glass-silicon-glass stack providing low RF capacitance and low CTE warpage. A second structured electrode layer may be arranged on a bottom surface of the second substrate 22B. In one example, the second structured electrode layer may be limited to RF electrodes and few ground electrodes, but may not necessarily include DC electrodes. The device 800 may referred to as three-dimensional ion trap and, for example, may be used for an atomic clock application.

Each of the substrates 22A and 22B may include one or more openings 46A and 46B configured to provide optical access to the interior space 44. Laser light may pass through the openings 46A and 46B and reach the trapped ions 38. In the illustrated example, laser light passing through the central openings 46A of the substrates 22A and 22B may directly hit the ions 38 in a substantially vertical direction. Alternatively, or additionally, laser light may pass through the laterally displaced openings 46B of the second substrate 22B and may be redirected by the mirrors 18 of the electronic components 80A and 80B to hit the ions 38 in a substantially horizontal direction. For example, the top and bottom optical access through openings 46A and 46B may allow loading of ions and detection of the states of the ions 38.

In a non-limiting example, dimensions of the device 800 and the electronic components 80A, 80B may be as follows. Dimensions *l* and w of the device 800 in the x- and y-direction may be about 4.5mm and 1.5mm, respectively. A dimension *h₁* of the first substrate 22A in the z-direction may be about 400um. A dimension *h₂* of the electronic components 80A and 80B in the z-direction may be about 400um. A dimension *h₃* of the second substrate 22B in the z-direction may be about 400um. However, these values are in no way limiting and are only intended to illustrate an order of magnitude of the dimensions of the illustrated arrangement.

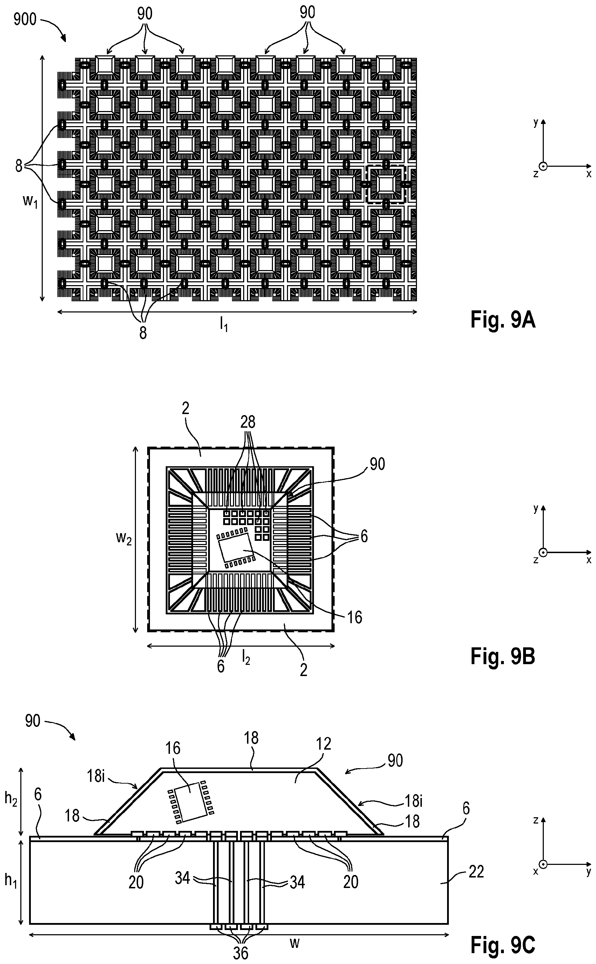

Figure 9A schematically illustrates a top view 900 of a device for controlling trapped ions in accordance with the disclosure. The device 900 may include a plurality of electronic components 90 which may be arranged over a structured electrode layer. The structured electrode layer may form a rectangular grid pattern of shuttling paths extending between the electronic components 90. A plurality of X-junctions may be arranged at intersections of the shuttling paths. It is to be noted that the example of Figure 9A shows an efficient and simple scaling of an ion trap device to larger sizes using a plurality of electronic components 90 in accordance with the disclosure. The ion trap device may thus be referred to as large scale ion trap.

Figures 9B and 9C schematically illustrates a top view and a side view of a detail of the ion trap device 900. More particular, a structured electrode layer including RF electrodes 2 and DC electrodes 6 as well as an electronic component 90 arranged thereon are shown. In the exemplary top view of Figure 9B, the electronic component 90 may have a rectangular footprint and the inclined portion 18i of the mirror 18 may extend over all four side surfaces of the semiconductor substrate 12. In the illustrated example, the structured electrode layer and/or the electronic component 90 may be electrically accessible via electrical connection elements 34 (such as TSVs and/or TGVs) extending through the substrate 22 and electrical contacts 36 arranged on the bottom surface of the substrate 22. The illustrated arrangement may include further elements which have been described in connection with previous examples.

In a non-limiting example, dimensions of the device 900 and the electronic components 90 may be as follows. Dimensions *l₁* and *w₂* of the device 900 in the x- and y-direction may be in a range from about 5mm to about 10mm each. Dimensions *l₂* and *w₂* of the electronic component 90 in the x- and y-direction may be in a range from about 1mm to about 2mm each. A dimension *h₁* of the substrate 22 in the z-direction may be greater than about 400um. A dimension *h₂* of the electronic components 90 in the z-direction may be about 100um. However, these values are in no way limiting and are only intended to illustrate an order of magnitude of the dimensions of the illustrated arrangement.

It is to be noted that one or more components of the devices described herein may be at least partially manufactured based on a micro-fabrication technique. For example, structured electrode layers as previously described may be formed based on a micro-fabrication technique. Micro-fabrication techniques (e.g. for electrode formation and structuring) may include one or more of photolithography processes (such as photoresist application, patterning, etching), deposition processes (such as CVD, PVD, sputtering), plating processes (such as electroless plating, galvanic plating), etching processes, or the like. Electrodes formed in a structured electrode layer may be structured with micrometer or sub-micrometer scale precision and alignment accuracy, thereby allowing complex electrode layouts without loss of controllability of trapped ions.

It is to be understood that devices in accordance with the disclosure may include various additional components which may have not been illustrated and described in detail for the sake of simplicity. For example, the described devices may further include at least one of a memory zone, a gate zone, a state readout zone, a loading zone, a laser source, a microwave source, means for controlling voltages applied to DC electrodes and/or RF electrodes, X-junctions, T-junctions, etc.

### Examples

In the following, electronic components, ion traps including such electronic components and devices for controlling trapped ions are described by means of examples.

Example 1 is an electronic component, comprising: a semiconductor substrate having a first major surface and a second major surface opposing the first major surface; an electronic circuit integrated into the semiconductor substrate; and a mirror arranged over the semiconductor substrate, wherein at least a portion of the mirror is inclined with respect to the first major surface of the semiconductor substrate; and at least one electrical contact configured to provide an electrical coupling between the electronic circuit and at least one electrode of an ion trap.

Example 2 is an electronic component according to Example 1, wherein the electronic circuit comprises: a multiplexer configured to provide a multiplexing between a plurality of DC electrodes of the ion trap and one or more voltage sources.

Example 3 is an electronic component according to Example 2, wherein the electronic circuit further comprises at least one of: digital electronics for controlling the one or more voltage sources, a digital interface, or a plurality of digital-to-analog converters.

Example 4 is an electronic component according to one of the preceding Examples, wherein the electronic circuit is integrated into the first major surface of the semiconductor substrate.

Example 5 is an electronic component according to one of the preceding Examples, wherein the inclined portion of the mirror comprises a flat surface and is arranged directly on the semiconductor substrate.

Example 6 is an electronic component according to Example 5, wherein an angle between the flat surface of the inclined portion of the mirror and the first major surface of the semiconductor substrate is in a range from 20 degrees to 160 degrees.

Example 7 is an electronic component according to one of the preceding Examples, wherein the inclined portion of the mirror covers a side surface of the semiconductor substrate extending between the first major surface and the second major surface.

Example 8 is an electronic component according to one of the preceding Examples, wherein: a footprint of the electronic component is rectangular, the inclined portion of the mirror extends over three side surfaces of the semiconductor substrate, and a fourth side surface of the semiconductor substrate comprises a dicing edge.

Example 9 is an electronic component according to one of Examples 1 to 7, wherein: a footprint of the electronic component is rectangular, and the inclined portion of the mirror extends over all four side surfaces of the semiconductor substrate.

Example 10 is an electronic component according to one of the preceding Examples, further comprising: at least one electrical contact arranged over the second major surface of the semiconductor substrate; and at least one electrical connection element extending through the semiconductor substrate and providing an electrical coupling between the electronic circuit and the at least one electrical contact.

Example 11 is an ion trap, comprising the electronic component of one of the preceding Examples.

Example 12 is a device for controlling trapped ions, the device comprising: a substrate having a main surface; a structured electrode layer arranged over the main surface of the substrate, wherein the structured electrode layer forms a plurality of electrodes of an ion trap configured to trap ions in a zone above the structured electrode layer; at least one electronic component arranged over the main surface of the substrate, wherein each of the at least one electronic component comprises: a semiconductor substrate; an electronic circuit integrated into the semiconductor substrate, wherein the electronic circuit is electrically coupled to at least one of the plurality of electrodes of the ion trap; and a mirror arranged over the semiconductor substrate, wherein at least a portion of the mirror is inclined with respect to the main surface of the substrate.

Example 13 is a device according to Example 12, wherein the mirror is configured to: receive laser light in a direction substantially non-parallel to the main surface of the substrate and to redirect the laser light in a direction substantially parallel to the main surface of the substrate, and/or receive laser light in a direction substantially parallel to the main surface of the substrate and to redirect the laser light in a direction substantially non-parallel to the main surface of the substrate.

Example 14 is a device according to Example 12 or 13, wherein the substrate comprises a recess and the at least one electronic component is arranged in the recess.

Example 15 is a device according to one of Examples 12 to 14, wherein: the structured electrode layer extends along one direction, and the at least one electronic component comprises two electronic components arranged on opposite sides of the structured electrode layer.

Example 16 is a device according to one of Examples 12 to 14, wherein: the at least one electronic component comprises a plurality of electronic components arranged in a rectangular grid pattern, and the structured electrode layer forms a rectangular grid pattern of shuttling paths extending between the plurality of electronic components.

The features of the various examples described herein may be combined with each other unless specifically noted otherwise. Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. An electronic component, comprising:
a semiconductor substrate (12) having a first major surface (14A) and a second major surface (14B) opposing the first major surface (14A);
an electronic circuit (16) integrated into the semiconductor substrate (12); and
a mirror (18) arranged over the semiconductor substrate (12), wherein at least a portion (18i) of the mirror (18) is inclined with respect to the first major surface (14A) of the semiconductor substrate (12); and
at least one electrical contact (20) configured to provide an electrical coupling between the electronic circuit (16) and at least one electrode of an ion trap.

2. The electronic component of claim 1, wherein the electronic circuit (16) comprises:
a multiplexer configured to provide a multiplexing between a plurality of DC electrodes (6) of the ion trap and one or more voltage sources.

3. The electronic component of claim 2, wherein the electronic circuit (16) further comprises at least one of:
digital electronics for controlling the one or more voltage sources, a digital interface, or a plurality of digital-to-analog converters.

4. The electronic component of one of the preceding claims, wherein the electronic circuit (16) is integrated into the first major surface (14A) of the semiconductor substrate (12) .

5. The electronic component of one of the preceding claims, wherein the inclined portion (18i) of the mirror (18) comprises a flat surface and is arranged directly on the semiconductor substrate (12).

6. The electronic component of claim 5, wherein an angle between the flat surface of the inclined portion (18i) of the mirror (18) and the first major surface (14A) of the semiconductor substrate (12) is in a range from 20 degrees to 160 degrees.

7. The electronic component of one of the preceding claims, wherein the inclined portion (18i) of the mirror (18) covers a side surface of the semiconductor substrate (12) extending between the first major surface (14A) and the second major surface (14B).

8. The electronic component of one of the preceding claims, wherein:
a footprint of the electronic component is rectangular,
the inclined portion (18i) of the mirror (18) extends over three side surfaces of the semiconductor substrate (12), and
a fourth side surface of the semiconductor substrate (12) comprises a dicing edge (42).

9. The electronic component of one of claims 1 to 7, wherein:
a footprint of the electronic component is rectangular, and
the inclined portion (18i) of the mirror (18) extends over all four side surfaces of the semiconductor substrate (12) .

10. The electronic component of one of the preceding claims, further comprising:
at least one electrical contact (28) arranged over the second major surface (14B) of the semiconductor substrate (12); and
at least one electrical connection element (32) extending through the semiconductor substrate (12) and providing an electrical coupling between the electronic circuit (16) and the at least one electrical contact (28).

11. An ion trap, comprising the electronic component of one of the preceding claims.

12. A device for controlling trapped ions, the device comprising:
a substrate (22) having a main surface (24);
a structured electrode layer arranged over the main surface (24) of the substrate (22), wherein the structured electrode layer forms a plurality of electrodes of an ion trap configured to trap ions (38) in a zone above the structured electrode layer;
at least one electronic component arranged over the main surface (24) of the substrate (22), wherein each of the at least one electronic component comprises:
a semiconductor substrate (12);
an electronic circuit (16) integrated into the semiconductor substrate (12), wherein the electronic circuit (16) is electrically coupled to at least one of the plurality of electrodes of the ion trap; and
a mirror (18) arranged over the semiconductor substrate (12), wherein at least a portion (18i) of the mirror (18) is inclined with respect to the main surface (24) of the substrate (22).

13. The device of claim 12, wherein the mirror (18) is configured to:
receive laser light in a direction substantially non-parallel to the main surface (24) of the substrate (22) and to redirect the laser light in a direction substantially parallel to the main surface (24) of the substrate (22), and/or
receive laser light in a direction substantially parallel to the main surface (24) of the substrate (22) and to redirect the laser light in a direction substantially non-parallel to the main surface (24) of the substrate (22).

14. The device of claim 12 or 13, wherein the substrate (22) comprises a recess and the at least one electronic component is arranged in the recess.

15. The device of one of claims 12 to 14, wherein:
the structured electrode layer extends along one direction, and
the at least one electronic component comprises two electronic components arranged on opposite sides of the structured electrode layer.

16. The device of one of claims 12 to 14, wherein:
the at least one electronic component comprises a plurality of electronic components arranged in a rectangular grid pattern, and
the structured electrode layer forms a rectangular grid pattern of shuttling paths extending between the plurality of electronic components.
